# EUROPEAN PATENT APPLICATION

(11) **EP 4 704 523 A1**
(43) Date of publication of application: **04.03.2026**
(21) Application number: 25186296.7
(22) Date of filing: 30.06.2025
(51) Int. Cl.: H10F 19/90, H10F 77/20

(54) **CONDUCTIVE COMPONENT, SOLAR CELL STRING, AND PHOTOVOLTAIC MODULE**

(30) Priority: 03.09.2024 CN 202411238689
(71) Applicant: TONGWEI SOLAR (HEFEI) CO., LTD., Hefei, Anhui 230088 (CN)
(72) Inventor: SUN, Jun, Hefei, 230088 (CN); WANG, Xuekui, Hefei, 230088 (CN); XU, Shunli, Hefei, 230088 (CN); DING, Jiating, Hefei, 230088 (CN)
(74) Representative: Gill Jennings & Every LLP

(57) **Abstract**

The present application relates to a conductive component, a solar cell string, and a photovoltaic module. An outer periphery of the conductive component (130) is defined with a plurality of welding regions (131) and a plurality of adhesive bonding region (132). The welding regions and the adhesive bonding regions are arranged alternately in a first direction. The outer periphery of the conductive component is provided with a plurality of flux parts (135) respectively corresponding to the plurality of welding regions. Each of the flux parts is at least partially coated, along a perimetral direction of the conductive component, on the conductive component in a corresponding one of the welding regions.

## Description

### TECHNICAL FIELD

The present application relates to the field of photovoltaic technology, and in particular, to a conductive component, a solar cell string, and a photovoltaic module.

### BACKGROUND

With the continuous advancement of photovoltaic module technology, the number of busbars on cells has evolved from multi-busbar (MBB) to super multi-busbar (SMBB). The multi-busbar technology for photovoltaic modules modifies the design and manufacture of the cells in the photovoltaic modules. A conventional photovoltaic module typically employs 2 to 5 busbars, while the multi-busbar technology may utilize 9 or even more busbars.

The busbarless technology (0BB for short) is an emerging manufacturing approach for photovoltaic modules that improves the efficiency of the solar cells and reduces the costs. In crystalline silicon solar cells, grid lines are metal wires used for current collection, and these cells usually contain multiple busbars. The busbarless technology eliminates busbars altogether, instead employing a greater number of finer metal wires or conductive material wires for current collection. The connection between these metal wires or conductive material wires and the cells is typically achieved through alloy connections, such as metal welding, or non-alloy connections, such as adhesive bonding.

In the early stages, the metal wires or conductive material wires used lacked fluxing substances on their surfaces, and a flux was typically sprayed onto the busbars of the cells. However, as photovoltaic technology has advanced, the metal wires have become increasingly finer, resulting in a relative decrease in the amount of the fluxing substance required for each wire. In addition, to avoid the adverse effects such as flux residue caused by uneven spraying of the flux on the cells, a method of soaking the metal wires entirely with the flux has been gradually adopted, which allows the surfaces of the metal wires to be provided with flux parts to ensure a firm and reliable alloy connection.

Currently, the method of soaking the metal wires entirely with the flux to obtain the flux parts is suitable for multi-busbar cell processes. However, applying this method to the current OBB adhesive bonding process presents significant challenges: when the entire metal wire is provided with the fluxing substance on its surface, the acidic substance in the flux can inhibit the activity of the catalytic substance in the adhesive. Additionally, the acidic substance in the flux can form an alloy coating on the surface of the metal wire, which reduces the bonding force between the adhesive and the metal wire.

In summary, using the metal wires entirely soaked with the flux in the OBB adhesive bonding process adversely affects the firmness of the non-alloy connection, leading to insufficient bonding force between the metal wires and the cell, then resulting in poor and loose solder joints between the metal wires and the cell, and finally affecting the performance of the photovoltaic module in use.

### SUMMARY

In view of this, to address the problem that when the metal wires entirely soaked with the flux are applied to the OBB adhesive bonding process of the cell, an insufficient bonding force between the metal wires and the cell is caused, there is a need to provide a conductive component, a solar cell string, and a photovoltaic module that can achieve an increased bonding force between the conductive component and the fixing adhesive dots, ensure the reliability of the connection between the conductive component and the cell, and avoid the issues of poor and loose solder joints between the conductive component and the cell, thereby ensuring the performance of the photovoltaic module in use.

In a first aspect, a conductive component is provided. An outer periphery of the conductive component is defined with a plurality of welding regions and a plurality of adhesive bonding regions. The welding regions and the adhesive bonding regions are alternately arranged in a first direction.

The outer periphery of the conductive component is further provided with a plurality of flux parts respectively corresponding to the plurality of welding regions. Each of the flux parts is at least partially coated, along a perimetral direction of the conductive component, on the conductive component in a corresponding one of the welding regions.

In an embodiment of the present application, in the first direction, one of the welding regions is located at an end of the conductive component, such that one of the flux parts is located at the end of the conductive component; or in the first direction, one of the adhesive bonding regions is located at an end of the conductive component.

In an embodiment of the present application, lengths of the welding regions in the first direction are equal to and/or different from lengths of the adhesive bonding regions in the first direction.

Alternatively or additionally, the welding regions have equal lengths and/or different lengths in the first direction.

Alternatively or additionally, the adhesive bonding regions have equal lengths and/or different lengths in the first direction.

In an embodiment, the lengths of the welding regions in the first direction are greater than the lengths of the adhesive bonding regions in the first direction.

In an embodiment, the conductive component is a conductive metal wire or a conductive metal strip.

The conductive component (130) has a diameter of 0.1 mm to 0.3 mm; or the conductive component (130) has a cross section in a shape of an equilateral triangle having a side length of 0.1 mm to 0.3 mm.

In an embodiment, the conductive component includes a conductive base and a metal coating coated on an outer side of the conductive base.

The flux parts are coated on the metal coating along the perimetral direction.

The flux parts are in a liquid state or in a solid state.

In a second aspect, a solar cell string is provided, including a cell, an adhesive part, and the conductive component described in the first aspect.

The adhesive part includes a plurality of fixing adhesive dots arranged spaced apart in the first direction on a surface of the cell and corresponding respectively to the adhesive bonding regions of the conductive component.

The conductive component is weldingly fixed to the surface of the cell through the flux parts in the welding regions, and adhesively bonded to the fixing adhesive dots in the adhesive bonding regions.

In an embodiment, lengths of the flux parts in the first direction are less than or equal to lengths of the respective welding regions in the first direction.

Alternatively or additionally, lengths of the fixing adhesive dots in the first direction are less than or equal to lengths of the respective adhesive bonding regions in the first direction.

In an embodiment, there is a plurality of adhesive parts arranged spaced apart in a second direction perpendicular to the first direction on the surface of the cell.

There is a plurality of conductive components. Each of the adhesive parts is connected to one of the conductive components, and each of the conductive components is provided with the plurality of flux parts spaced apart from each other.

In an embodiment, the surface of the cell is defined with a plurality of conductive regions arranged spaced apart in the first direction on the surface of the cell and extending in a second direction perpendicular to the first direction.

The conductive regions are corresponding to the welding region. The conductive component is welded to the conductive regions of the cell through the flux parts in the welding regions.

Any adjacent two of the conductive regions is provided with a fixing adhesive dot of the plurality of fixing adhesive dots therebetween.

In an embodiment, the cell is provided with a plurality of conductive layers. Each of the conductive regions is provided with at least one of the conductive layers. The conductive layers extend in the second direction. When each of the conductive regions is provided with at least two of the conductive layers, the at least two of the conductive layers are spaced apart from each other in the first direction.

In a third aspect, a photovoltaic module is provided, including a cover plate, a back plate, and a plurality of solar cell strings described in the second aspect. The solar cell strings are connected in series in the first direction.

The cover plate and the back plate are respectively provided at two sides of the plurality of solar cell strings. The cover plate, the back plate, and the plurality of solar cell strings are encapsulated through an encapsulation process.

By adopting the above technical solutions, the present application has at least the following technical effects:

In the conductive component, the solar cell string, and the photovoltaic module in the present application, the outer periphery of the conductive component is defined with a plurality of welding regions and a plurality of adhesive bonding regions. The welding regions and the adhesive bonding regions are alternately arranged in the first direction on the conductive component. A plurality of flux parts are disposed in the plurality of welding regions, respectively. In this way, the conductive component is provided with the flux parts in the welding regions and without the flux parts in the adhesive bonding regions. When the conductive component is connected to the cell, the conductive component is welded to the surface of the cell through the flux parts in the welding regions, and bonded to the fixing adhesive dots in the adhesive bonding regions, so that the conductive component is fixed to the cell 110 through both welding connection and adhesive bonding.

As such, after the conductive component is fixed to the cell, the flux parts facilitate the weldingly fixation of the conductive component to the cell in the welding regions, and increase the firmness of the connection between the conductive component and the cell. Meanwhile, the flux parts of the conductive component do not make contact with the fixing adhesive dots, so that the bonding force between the conductive component and the fixing adhesive dots is increased, ensuring the reliability of the bonding connection between the conductive component and the cell, and then ensuring a sufficient tightening force between the conductive component and the cell, which ensures the reliability of the connection between the conductive component and the cell, avoids the issues of poor and loose solder joints between the conductive component and the cell, and ensures the performance of the photovoltaic module in use.

### BRIEF DESCRIPTION OF THE DRAWINGS

FIG. 1 is a schematic view of a solar cell string according to an embodiment of the present application.
FIG. 2 is a partially enlarged view of the solar cell string at the position A in FIG. 1.
FIG. 3 is a schematic view showing a correspondence between a conductive component, a cell, and an adhesive part in the solar cell string shown in FIG. 2.
FIG. 4 is a schematic sectional view of a conductive component in a first direction according to an embodiment.
FIG. 5 is a schematic view of a solar cell string according to another embodiment of the present application.
FIG. 6 is a partially enlarged view of the solar cell string at the position B in FIG. 5.
FIG. 7 is a schematic sectional view of the conductive component in the first direction according to another embodiment.
FIG. 8 is a schematic sectional view of the conductive component in the first direction according to yet another embodiment.

### Reference numerals

100-solar cell string; 110-cell; 111-conductive region; 112-conductive layer; 113-welding pad; 120-adhesive part; 121-fixing adhesive dot; 130-conductive component; 131-welding region; 132-adhesive bonding region; 133-conductive base; 134-metal coating; and 135-flux part.

### DETAILED DESCRIPTION

In the description of the present application, it should be understood that if the terms such as "center", "longitudinal", "transverse", "length", "width", "thickness", "upper", "lower", "front", "back", "left", "right", "vertical", "horizontal", "top", "bottom", "inside", "outside", "clockwise", "anticlockwise", "axial", "radial", and "perimetral" appear, orientation or position relationships indicated by these terms are based on orientation or position relationships shown in the accompanying drawings, and are intended to facilitate the description of the present application and simplify the description only, rather than indicate or imply that the mentioned apparatus or element must have a particular orientation or must be constructed and operated in a particular orientation. Therefore, such terms should not be construed as limiting the present application.

In addition, if the terms "first" and "second" appear, these terms are used merely for the purpose of description, and should not be construed as indicating or implying relative importance or implying a quantity of indicated technical features. Therefore, features defined with "first" and "second" may explicitly or implicitly include at least one of such features. In the description of the present application, if the term "a plurality of" appears, "a plurality of" means at least two, such as two or three, unless otherwise explicitly limited.

In the present application, unless otherwise explicitly specified and limited, if the terms "mount", "connect", "couple", and "fix" appear, these terms should be understood in a broad sense. For example, a connection may be a fixed connection, a detachable connection, or an integral connection; the connection may be a mechanical connection, or an electrical connection; or the connection may be a direct connection, an indirect connection through an intermediate medium, a communication between interiors of two elements, or an interaction relationship between the two elements, unless otherwise explicitly limited. Those of ordinary skill in the art should understand specific meanings of the above terms in the present application according to specific situations.

In the present application, unless otherwise explicitly specified and limited, if descriptions such as a first feature being "on" or "below" a second feature appear, it may mean that the first feature and the second feature are in direct contact, or that the first feature and the second feature are in indirect contact through an intermediary medium. In addition, the first feature being "over", "above", and "on" the second feature may be the first feature being over or above the second feature, or merely indicates that a level of the first feature is higher than that of the second feature. The first feature being "under", "below", and "underneath" the second feature may be the first feature being under or below the second feature, or merely indicates that the level of the first feature is lower than that of the second feature.

It should be noted that if an element is referred to as being "fixed to" or "arranged on" another element, the element may be directly arranged on another element or there may be an intermediate element. If an element is considered to be "connected to" another element, the element may be directly connected to another element or there may be an intermediate element at the same time. If present, the terms "vertical", "horizontal", "upper", "lower", "left", "right", and similar expressions used in the present application are for illustrative purposes only and do not represent the only implementation.

It should be understood that busbarless technology (0BB for short) utilizes a greater number of finer metal wires or conductive material wires to collect currents. The metal wires are entirely soaked with a flux such that a flux part is provided on surfaces of the metal wires to ensure a firm and reliable alloy connection. However, when the metal wires that are entirely provided with the flux on their surfaces are used, the acidic substance present in the flux may inhibit the activity of the catalytic substance in the adhesive, and additionally, create an alloy coating on the surfaces of the metal wires, causing reduced bonding force between the adhesive and the metal wires and thus insufficient bonding force between the metal wires and the cell, so that the issues of poor and loose solder joints between the metal wires and the cell tend to occur, which affects the performance of the photovoltaic module in use.

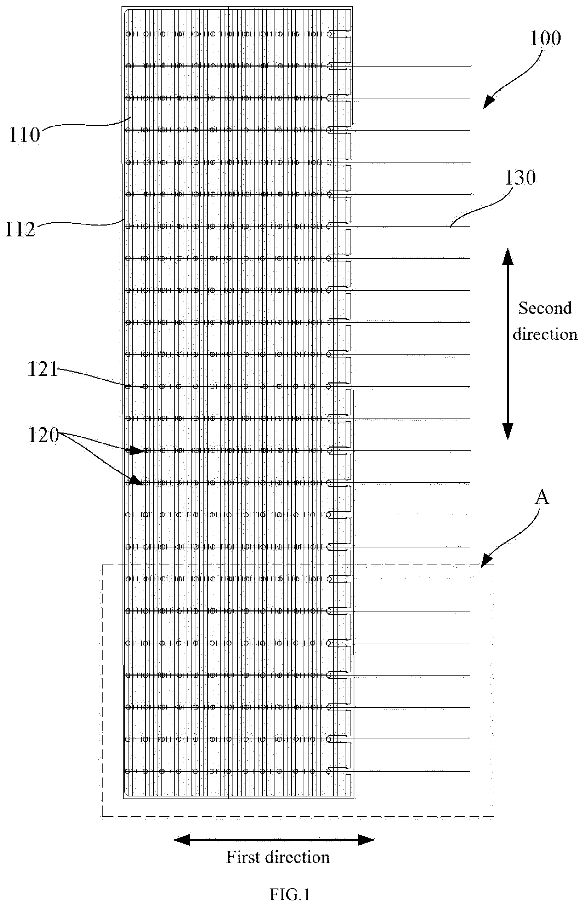

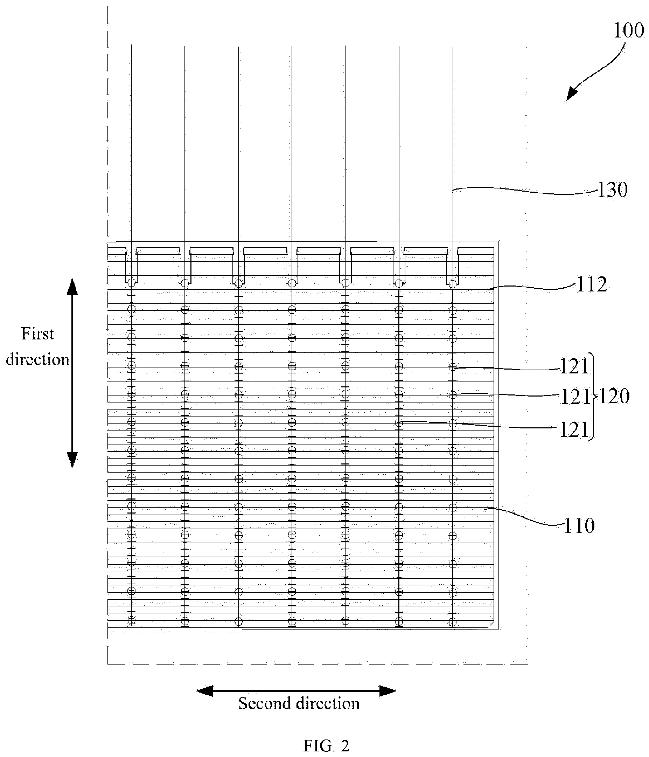

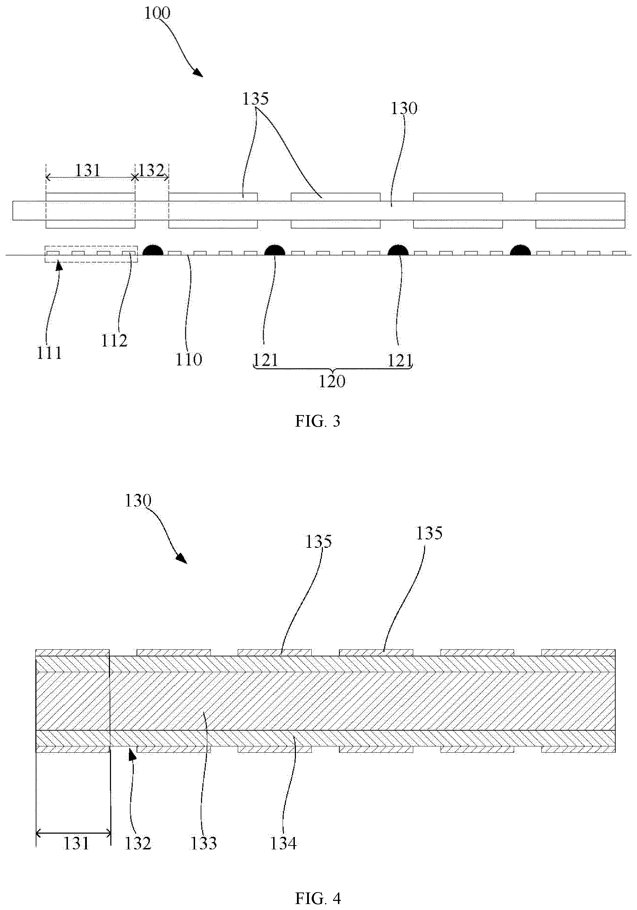

In view of this, referring to FIG. 1 to FIG. 4, the present application provides a conductive component 130. FIG. 1 is a schematic view of a solar cell string 100 according to an embodiment of the present application. FIG. 2 is a partially enlarged view of the solar cell string 100 at the position A in FIG. 1. FIG. 3 is a schematic view showing the correspondence between the conductive component 130, a cell 110, and an adhesive part 120 of the solar cell string 100 shown in FIG. 2. FIG. 4 is a schematic sectional view of the conductive component 130 in a first direction according to an embodiment. The conductive component 130 is applied in the solar cell string 100. A plurality of solar cell strings 100 can be connected to each other and encapsulated through an encapsulation process to form a photovoltaic module (not shown).

In the present application, by using the conductive component 130, the inhibition of the flux part 135 against the activity of the catalytic substance in the fixing adhesive dot 121 is avoided, and the bonding force between the flux part 135 and the fixing adhesive dot 121 is increased, so that the reliability of the welding connection between the conductive component 130 and the cell 110 is ensured, and then a sufficient tightening force between the component 130 and the cell 110 is ensured, which ensures the reliability of the connection between the component 130 and the cell 110, avoiding the issues of poor and loose solder joints between the conductive component 130 and the cell, and ensuring the performance of the photovoltaic module in use.

To better illustrate a specific structure of the conductive component 130, a structure of the solar cell string 100 is briefly described herein first. The solar cell string 100 includes a cell 110, an adhesive part 120, and a conductive component 130 according to the present application. The adhesive part 120 comprises a plurality of fixing adhesive dots 121 arranged spaced apart from each other in a first direction on a surface of the cell 110. The conductive component 130 can be weldingly fixed to the surface of the cell 110. Additionally, the conductive component 130 can be bondingly fixed to the surface of the cell 110 through the fixing adhesive dots 121.

The cell 110 is made from a silicon wafer. The cell 110 is configured to absorb the solar energy and convert the solar energy into the electrical energy. The specific structure and principle of the cell 110 can be referred to the prior art, and the details of the cell 110 will not be elaborated upon herein. The cell 110 extends in both a first direction and a second direction. The first direction and the second direction are as shown in FIG. 1 and FIG. 2. The first direction is substantially perpendicular to the second direction. The first direction is a length direction of the cell 110, and the second direction is a width direction of the cell 110. The solar cell 110 has a length in the first direction and a width in the second direction.

The conductive component 130 is disposed on the surface of the cell 110 along the first direction. Both an alloy connection and a non-alloy connection are formed between the conductive component 130 and the cell 110 to ensure a sufficient tightening force between the conductive component 130 and the cell 110, which ensures the reliability of the connection between the conductive component 130 and the cell 110. The adhesive part 120 is disposed on the surface of the cell 110. The conductive component 130 is bondingly fixed to the adhesive part 120, forming a non-alloy connection between the conductive component 130 and the cell 110. A region of the conductive component 130, other than that corresponding to the adhesive part 120, is welded to the cell 110, forming an alloy connection between the conductive component 130 and the cell 110.

Specifically, the adhesive part 120 is disposed on the surface of the cell 110 along the first direction, the conductive component 130 is disposed on the adhesive part 120, and the region of the conductive component 130, other than that corresponding to the adhesive part 120, is welded to the cell 110 to achieve an electrical connection between the conductive component 130 and the cell 110. It should be understood that the cell 110 has a front surface and a back surface that are opposite to each other. Only the front surface of the cell 110 is illustrated in FIG. 1 and FIG. 3, and the back surface of the cell 110 is not illustrated.

Furthermore, the front surface and the back surface of the cell 110 are each provided with the adhesive part 120, and each adhesive part 120 is fixed to one conductive component 130. That is, the upper surface (the front surface) and the lower surface (the back surface) of the cell 110 are each provided with the conductive component 130. The conductive component 130 is fixed to the surface of the cell 110 through the corresponding adhesive part 120 and the welding connection. It should be noted that the connection principle between the upper surface of the cell 110 and the conductive component 130 is essentially the same as that between the lower surface of the cell 110 and the conductive component 130. Hereinafter, only the connection between a surface of the cell 110 and the conductive component 130 is described as an example, which surface may be the upper surface or the lower surface.

The adhesive part 120 is disposed on the surface of the cell 110. The conductive component 130 is adhesively bonded to adhesive part 120 and welded to a region of the cell 110 without the adhesive part 120. In this way, the conductive component 130 can be fixed to the surface of the cell 110 by both the adhesive bonding and the welding connection, so that the conductive component 130 is reliably fixed to the cell 110. The adhesive bonding and the welding connection together provide a sufficient tightening force between the conductive component 130 and the cell 110, which ensures the reliability of the connection between the conductive component 130 and the cell 110. In addition, the cost is reduced, and the shading rate is decreased to ensure the photoelectric conversion efficiency.

In addition, after the conductive component 130 is weldingly fixed to the cell 110, an electrical connection can be formed between the region of the conductive component 130 other than that corresponding to the adhesive part 120 and the cell 110, ensuring the electrical contact property between the conductive component 130 and the cell 110, and allowing the conductive component 130 to normally collect the currents generated by the cell 110. Moreover, the fixing adhesive dots 121 of the adhesive part 120 are spaced apart from each other in the first direction, that is, there is a spacing between two adjacent fixing adhesive dots 121 in the first direction, allowing the conductive component 130 to be bondingly fixed to the surface of the cell 110.

The specific structure of the conductive component 130 according to an embodiment is described below.

Referring to FIG. 2 to FIG. 4, in an embodiment, an outer periphery of the conductive component 130 is defined with a plurality of welding regions 131 and a plurality of adhesive bonding regions 132. The welding regions 131 and the adhesive bonding regions 132 are alternately arranged in the first direction. The outer periphery of the conductive component 130 is further provided with a plurality of flux parts 135 respectively corresponding to the plurality of welding regions 131. Each of the flux parts 135 is at least partially coated on the conductive component 130 in the corresponding welding region 131 along a perimetral direction of the conductive component 130.

After the flux parts 135 are provided in the respective welding regions 131 of the conductive component 130, the flux parts 135 can facilitate the welding connection between the conductive component 130 and the cell 110 to further improve the firmness of the welding connection between the conductive component 130 and the cell 110. Herein, the flux part 135 is a flux layer coated on the conductive component 130.

Furthermore, the adhesive bonding regions 132 are arranged respectively corresponding to the fixing adhesive dots 121. The flux parts 135 are provided in the respective welding regions 131 of the conductive component 130, and there are no flux parts 135 in the adhesive bonding regions 132 of the conductive component 130. In this way, a plurality of flux parts 135 are arranged spaced apart in the first direction on the conductive component 130, with a spacing present between two adjacent flux parts 135, and this spacing is the adhesive bonding region 132.

In other words, an outer wall of the conductive component 130 is alternately provided with the flux layers and without the flux layers. The adhesive bonding regions 132 are provided with no flux layers and corresponding to the fixing adhesive dots 121. The welding regions 131 are provided with the flux layers, with the flux parts 135 corresponding to the regions of the solar cell without the fixing adhesive dots 121.

When the conductive component 130 is to be connected to the adhesive part 120 and the cell 110, the welding regions 131 of the conductive component 130 can be welded to the cell 110 through the flux parts 135, and the adhesive bonding regions 132 of the conductive component 130 can be adhesively bonded to the fixing adhesive dots 121. The flux parts 135 can facilitate the welding connection between the conductive component 130 and the cell 110 in the welding regions 131 to ensure the reliability of the welding connection between the conductive component 130 and the cell 110. The fixing adhesive dots 121 allow the bonding connection between the conductive component 130 and the cell 110.

Furthermore, since there are no flux parts 135 in the adhesive bonding regions 132, the inhibition of the acidic substance in the flux part 135 against the activity of the catalytic substance in the fixing adhesive dot 121 can be avoided, and the formation of the alloy coating by the flux part 135 will not occur on the portions of the conductive component 130 corresponding to the adhesive bonding regions 132. As a result, the bonding force of the fixing adhesive dots 121 through which the bonding connection is formed between the conductive component 130 and the cell 110 can be ensured, thereby ensuring the firmness of the non-alloy connection between the conductive component 130 and the cell 110 and thus the reliability of the connection between the conductive component 130 and the cell 110, avoiding the issues of poor and loose solder joints between the conductive component 130 and the cell 110, and ensuring the output power of the photovoltaic module.

In the above embodiment, the outer periphery of the conductive component 130 is defined with the plurality of welding regions 131 and the plurality of adhesive bonding regions 132. The welding regions 131 are arranged alternately with the adhesive bonding regions 132. The conductive component 130 is provided with the flux parts 135 in the welding regions 131 and without the flux parts 135 in the adhesive bonding regions 132. After the conductive component 130 is fixed to the cell 110, the flux parts 135 facilitates the welding fixation of the conductive component 130 to the cell 10 in the welding regions 131 and increases the firmness of the connection between the conductive component 130 and the cell 110. Additionally, the flux parts 135 of the conductive component 130 do not come into contact with the fixing adhesive dots 121, so that the bonding force between the conductive component 130 and the fixing adhesive dots 121 is increased, ensuring the reliability of the bonding connection between the conductive component 130 and the cell 110, and then ensuring a sufficient tightening force between the conductive component 130 and the cell 110, which ensures the reliability of the connection between the conductive component 130 and the cell 110, avoids the issues of poor and loose solder joints between the conductive component 130 and the cell 110, and ensures the performance of the photovoltaic module in use.

Referring to FIG. 3 and FIG. 4, in an embodiment, the flux part 135 is completely coated on a peripheral side of the conductive component 130 in the welding region 131. That is, the flux part 135 is completely coated on the conductive component 130 in the welding region 131 along a peripheral side of the conductive component 130. An outer wall of the conductive component 130 in the welding region 131 is coated with the flux part 135. In this way, when the conductive component 130 is welded to the cell 110 in the welding regions 131, the flux parts 135 can improve the reliability of the welding connection between the conductive component 130 and the cell 110.

It should be understood that, in other embodiments of the present application, the flux part 135 may be coated on a surface of the conductive component 130 facing the cell 10 in the welding region 131. That is, the flux part 135 is disposed on a bottom surface of the conductive component 130 in the welding region 131. When the conductive component 130 is welded to the cell 110, the flux parts 135 can ensure the reliability of the connection between the conductive component 130 and the cell 110.

Referring to FIG. 1 to FIG. 4, in an embodiment of the present application, the cell 110 is a busbarless cell. The conductive component 130 is fixed to the surface of the cell 110 along the first direction through a plurality of fixing adhesive dots 121. In this case, the conductive component 130 is defined with the welding regions 131 and the adhesive bonding regions 132 that are arranged alternately with each other, and the flux parts 135 are disposed in the welding regions 131, so that both the welding connection and the adhesive bonding connection between the conductive component 130 and the cell 110 can be achieved, and the contact between the flux parts 135 and the fixing adhesive dots 121 can be avoided.

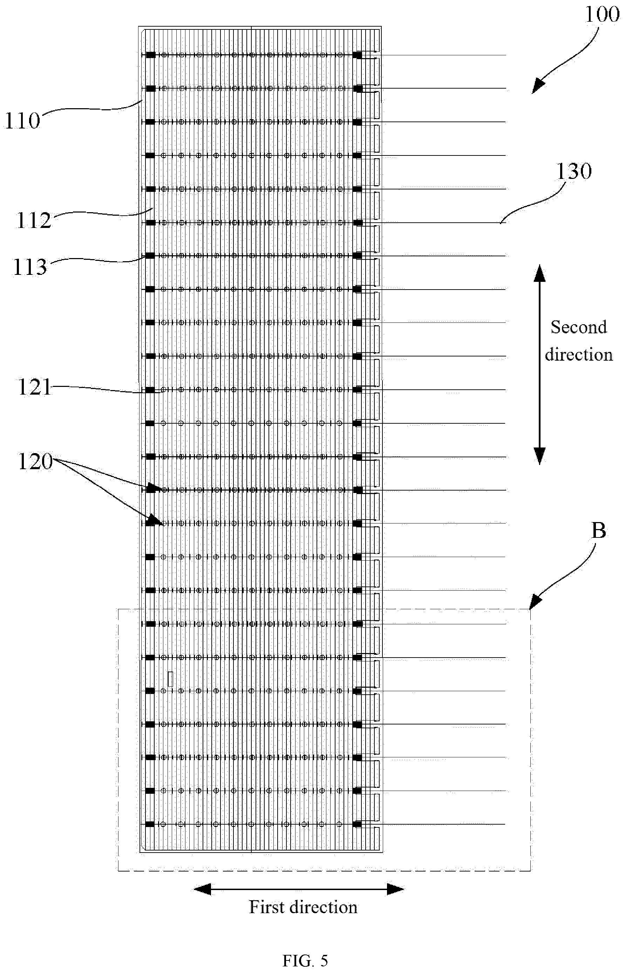

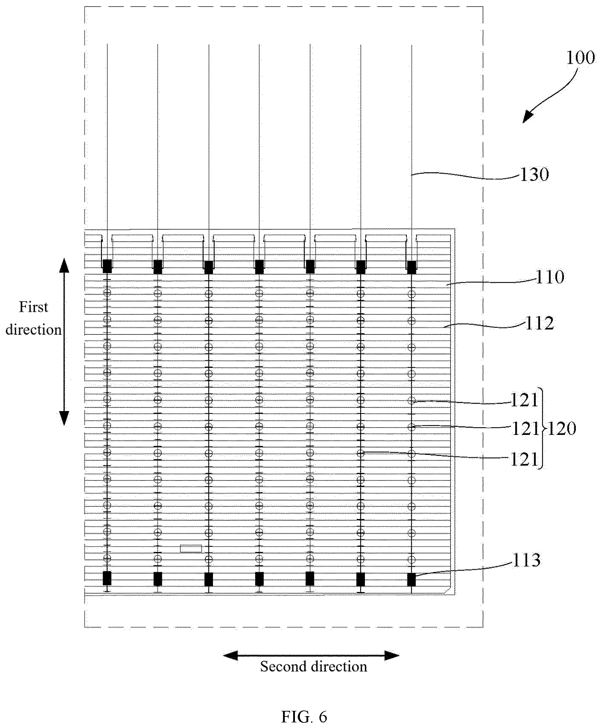

Referring to FIG. 5 and FIG. 6, in another embodiment of the present application, the cell 110 is a busbarless cell. The conductive component 130 is fixed to the surface of the cell 110 along the first direction through a plurality of fixing adhesive dots 121 and a welding pad 113. The conductive component 130 is welded to the welding pad 113 and the cell 110 and is adhesively bonded to the fixing adhesive dots 121 and the cell 110. FIG. 5 is a schematic view of a solar cell string 100 according to another embodiment of the present application. FIG. 6 is a partially enlarged view of the solar cell string 100 at the position B in FIG. 5.

The plurality of fixing adhesive dots 121 are arranged in the first direction, and the welding pad 113 is arranged at each end of the plurality of fixing adhesive dots 121, creating a structural form with the welding pads 113 at both ends and the plurality of fixing adhesive dots 121 in the middle. The flux parts 135 are disposed in the welding regions 131. In this way, the conductive component 130 is welded to the welding pads 113 and the regions of the cell 110 without the fixing adhesive dots 121, and is adhesively bonded to the fixing adhesive dots 121 in the adhesive bonding regions 132, and the contact between the flux parts 135 and the fixing adhesive dots 121 is avoided.

It should be understood that, in other embodiments of the present application, a busbar may further be disposed on the cell 110.

Referring to FIG. 3 and FIG. 4, in an embodiment, the flux parts 135 are in a liquid state. That is, the flux parts 135 are liquid flux layers. It should be understood that, in other embodiments of the present application, the flux parts 135 may be in a solid state. That is, the flux parts 135 may be solid flux layers.

The flux parts 135 are mainly formed by coating a flux on the welding regions 131 of the conductive component 130. The flux can reduce the surface tension of the solder and improve the welding performance, thereby improving the reliability of the welding connection between the conductive component 130 and the cell 110. It should be noted that a specific material of the flux can be referred to the prior art, which will not be elaborated upon herein.

Moreover, the flux parts 135 of the conductive component 130 are obtained by soaking the conductive component 130 entirely. Specifically, a flux tank containing the flux is provided. Before welding the conductive component 130 to the cell 110, the conductive component 130 is passed through the flux tank and is entirely soaked with the flux in the flux tank, such that a flux layer is formed on the surface of the conductive component 130. After the conductive component 130 is pulled out of the flux tank, portions of the flux layer in the adhesive bonding regions 132 of the conductive component 130 are evaporated through a heating method or other methods, that is, the portions of the flux layer in the adhesive bonding regions 132 are removed. In this way, other portions of the flux layer remained on the conductive component 130 in the welding regions 131 forms the flux parts 135, while no flux layer is remained in the adhesive bonding regions 132.

Then, the conductive component 130 is transferred on the cell 110. The conductive component 130 is welded to the surface of the cell 110 in the welding regions 131 through the flux parts, and is adhesively bonded to the fixing adhesive dots 121 in the adhesive bonding regions 132, thereby achieving the welding connection and the adhesive bonding connection between the conductive component 130 and the cell 110, which ensures the reliable connection between the conductive component 130 and the cell 110 while increasing the bonding force between the conductive component 130 and the cell 110.

Referring to FIG. 1 to FIG. 4, in an embodiment, the surface of the cell 110 is defined with a conductive region 111. A plurality of conductive regions 111 are arranged spaced apart from each other in the first direction on the surface of the cell 110 and extend in the second direction perpendicular to the first direction. The conductive regions 111 are arranged respectively corresponding to the welding regions 131. The conductive component 130 is welded to the conductive regions 111 of the cell 110 through the flux parts 135 in the welding regions 131. Two adjacent conductive regions 111 are provided with the fixing adhesive dot 121 therebetween.

The cell 110 is of a busbarless structure. The surface of the cell 110 is defined with a plurality of conductive regions 111 through which the currents of the cell 110 are collected. The conductive regions 111 extend in the second direction. The plurality of conductive regions 111 are spaced apart from each other in the first direction. The conductive component 130 is intersected with the conductive regions 111. For example, the conductive component 130 is perpendicular to the conductive regions 111. The currents generated by the cell 110 and collected in the conductive regions 111 are converged and transmitted through the conductive component 130.

The fixing adhesive dot 121 is provided between adjacent conductive regions 111, so that the conductive component 130 can be bondingly fixed to cell 110 through the fixing adhesive dot 121. That is, the conductive regions 111 and the fixing adhesive dots 121 are arranged alternately in the first direction. Additionally, the welding regions 131 and the adhesive bonding regions 132 of the conductive component 130 are arranged alternately in the first direction. When the conductive component 130 is located corresponding to the cell 110, the welding regions 131 and the flux parts 135 thereon are located corresponding to the conductive regions 111 of the cell 110, and the adhesive bonding regions 132 are located corresponding to the fixing adhesive dots 121 on the cell 110, as shown in FIG. 3.

In this way, when the conductive component 130 is to be connected to the cell 110, the conductive component 130 is welded to the conductive regions 111 of the cell 110 through the flux parts 135 in the welding regions 131, so that the conductive component 130 is fixed to the cell 110 to achieve an electrical connection between the conductive component 130 and the conductive regions 111. Meanwhile, the fixing adhesive dots 121 are bonded to the adhesive bonding regions 132. In this way, the flux parts 135 in the welding regions 131 do not affect the activity of the catalytic substance in the fixing adhesive dots 121, thereby enhancing the bonding force between the conductive component 130 and the fixing adhesive dots 121 in the adhesive bonding regions 132, and further reliably fixing the conductive component 130 to the cell 110.

Referring to FIG. 1 to FIG. 3, in an embodiment, the cell 110 is provided with a plurality of conductive layers 112. At least one conductive layer 112 is provided in each conductive region 111. The conductive layer 112 extends in the second direction. When at least two conductive layers 112 are provided in the conductive region 111, the at least two first conductive layers 112 are arranged in the first direction. In other words, each conductive region 111 may be provided with at least one conductive layer 112 extending in the second direction. The conductive layers 112 are made of a conductive material. The currents of the cell 110 are collected through the conductive layers 112.

The conductive component 130 is welded to the conductive layers 112 through the flux parts 135 in the welding regions 131. The currents collected by the conductive layers 112 are converged and transmitted through the conductive component 130. Moreover, when each conductive region 111 is provided with at least two conductive layers 112, the at least two conductive layers 112 are spaced apart in the first direction, with a spacing present between two adjacent conductive layers 112 in the first direction, and a portion of the conductive component 130 in the welding region 131 can be welded to the conductive layers 112 in a single conductive region 111 simultaneously.

Optionally, the conductive layer 112 is a grid line, a metal wire, or other component that can achieve collection of currents. Optionally, the numbers of the conductive layers 112 in the individual conductive regions 111 may be the same or different. As shown in FIG. 3, in this embodiment, four conductive layers 112 are provided in each conductive region 111. It should be understood that, in other embodiments of the present application, other numbers of conductive layers 112 may be provided in each conductive region 111.

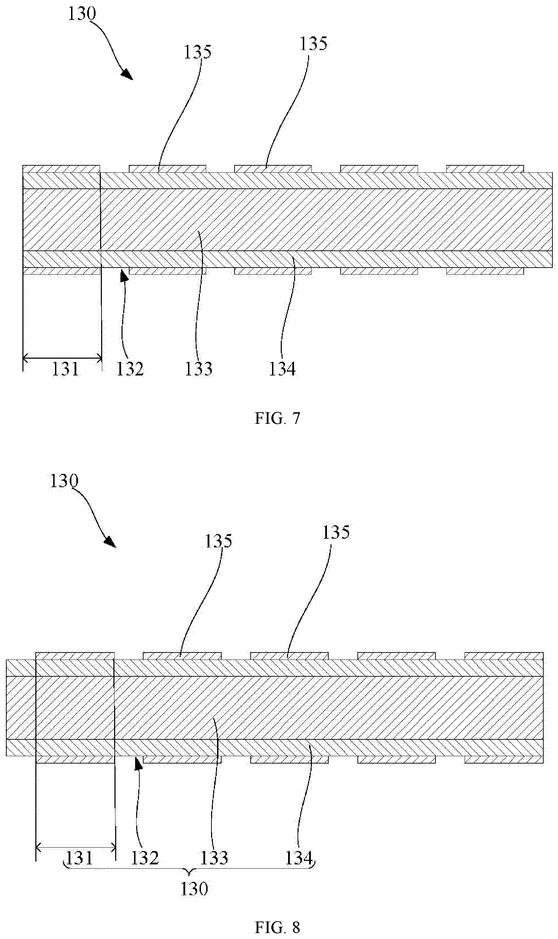

Referring to FIG. 4 and FIG. 7, in an embodiment, an end of the conductive component 130 in the first direction is defined with the welding region 131, such that the end of the conductive component 130 is provided with the flux part 135. FIG. 7 is a schematic sectional view of the conductive component in the first direction according to another embodiment.

In FIG. 4 and FIG. 7, the left end of the conductive component 130 is defined with the welding region 131, from which the outer wall of the conductive component 130 is defined with the welding regions 131 and the adhesive bonding regions 132 arranged in an order of welding region 131-adhesive bonding region-welding region 131-adhesive bonding region 132, and so on. Accordingly, the left end of the cell 110 is defined with the conductive region 111, from which the cell 110 is provided with the conductive regions 111 and the fixing adhesive dots 121 arranged in an order of conductive region 111-fixing adhesive dot 121-conductive region 111-fixing adhesive dot 121, and so on.

In this way, the welding regions 131 and the flux parts 135 of the conductive component 130 can have a one-to-one correspondence with the conductive regions 111 of the cell 110, while the adhesive bonding regions 132 can have a one-to-one correspondence with the fixing adhesive dots 121 on the solar cell 110. When the conductive component 130 is connected to the cell 110, the conductive component 130 is welded to the conductive regions 111 of the cell 110 through the flux parts 135 in the welding regions 131, and bonded to the fixing adhesive dots 121 in the adhesive bonding regions 132. This enhances the bonding force of the fixing adhesive dots 121 through which the conductive component 130 is bonded to the cell 110, and improves the reliability of the connection between the conductive component 130 and the cell 110.

Referring to FIG. 3 and FIG. 8, in another embodiment, an end of the conductive component 130 in the first direction is defined with the adhesive bonding region 132, such that a predetermined spacing is present between the outermost flux part 135 in the welding region 131 and the end of the conductive component 130. FIG. 8 is a schematic sectional view of the conductive component 130 according to yet another implementation.

In FIG. 3 and FIG. 8, the left end of the conductive component 130 is defined with the adhesive bonding region 132, from which the outer wall of the conductive component 130 is defined with the welding regions 131 and the adhesive bonding regions 132 arranged in an order of adhesive bonding region-welding region 131-adhesive bonding region 132-welding region 131, and so on. Accordingly, the left end of the cell 110 is provided with the fixing adhesive dot 121, from which the cell 110 is provided with the conductive regions 111 and the fixing adhesive dots 121 arranged in an order of fixing adhesive dot 121-conductive region 111-fixing adhesive dot 121-conductive region 111, and so on.

In this way, the welding regions 131 and the flux parts 135 of the conductive component 130 can have a one-to-one correspondence with the conductive regions 111 of the cell 110, while the adhesive bonding regions 132 can have a one-to-one correspondence with the fixing adhesive dots 121 on the solar cell 110. When the conductive component 130 is connected to the cell 110, the conductive component 130 is welded to the conductive regions 111 of the cell 110 through the flux parts 135 in the welding regions 131, and bonded to the fixing adhesive dots 121 in the adhesive bonding regions 132. This enhances the bonding force of the fixing adhesive dots 121 through which the conductive component 130 is bonded to the cell 110, and improves the reliability of the connection between the conductive component 130 and the cell 110.

It should be understood that, in an embodiment, when the left end of the conductive component 130 is defined with the adhesive bonding region 132, a predetermined spacing may be present between the outermost flux part 135 in the welding region 131 and the left end of the conductive component 130. In this case, no fixing adhesive dot 121 may be provided on the leftmost end of the cell 110, that is, no fixing adhesive dot 121 may be provided corresponding to the leftmost adhesive bonding region 132.

It should be noted that, the numbers of the welding regions 131 and the adhesive bonding regions 132 of the conductive component 130 are not limited herein in principle, as along as it is ensured that the welding regions 131 and the adhesive bonding regions 132 are alternately arranged in the first direction of the conductive component 130, with the flux parts 135 provided in the welding regions 131 and no flux parts 135 provided in the adhesive bonding regions 132. The numbers of the welding regions 131 and the adhesive bonding regions 132 are varied depending on a length of the conductive component 130 in the first direction. The length of the conductive component 130 in the first direction is varied depending on a length of the cell 110 in the first direction.

In an embodiment, lengths of the welding regions 131 in the first direction are equal to and/or different from lengths of the adhesive bonding regions 132 in the first direction. It should be noted that the lengths of the welding regions 131 in the first direction and the lengths of the adhesive bonding regions 132 in the first direction are not limited in principle, as long as the welding regions 131 and the adhesive bonding regions 132 are alternately arranged in the first direction on the conductive component 130, with the flux parts 135 provided in the welding regions 131 and no flux parts 135 provided in the adhesive bonding regions 132.

Optionally, the lengths of the welding regions 131 in the first direction are equal to the lengths of the adhesive bonding regions 132 in the first direction. In other words, the welding regions 131 and the adhesive bonding regions 132 are of equal lengths and are alternately arranged in the first direction on the conductive component 130. Referring to FIG. 3, FIG. 4,

FIG. 6, and FIG. 7, optionally, the lengths of the welding regions 131 in the first direction may be different from the lengths of the adhesive bonding regions 132 in the first direction. In other words, the welding regions 131 and the adhesive bonding regions 132 are of different lengths and are alternately arranged in the first direction on the conductive component 130.

It should be understood that, in other embodiments of the present application, the lengths of a part of the welding regions 131 in the first direction may be equal to the lengths of the adhesive bonding regions 132 in the first direction, while the length of another part of the welding regions 131 in the first direction may be different from the lengths of the adhesive bonding regions 132 in the first direction, as long as the welding regions 131 and the adhesive bonding regions 132 are alternately arranged in the first direction on the conductive component 130.

Referring to FIG. 3, FIG. 4, FIG. 6, and FIG. 7, in an embodiment, the lengths of the individual welding regions 131 in the first direction are equal to and/or different from each other. The lengths of the welding regions 131 in the first direction are not limited in principle, as long as the flux parts 135 can be provided in the welding regions 131, and the conductive component 130 can be welded to the conductive regions 111 of the cell 110 through the flux parts 135 in the welding regions 131 to achieve the electrical connection between the conductive component 130 and the cell 110.

In an embodiment, referring to FIG. 3, FIG. 4, FIG. 6, and FIG. 7, the lengths of the individual welding regions 131 in the first direction are equal to each other. That is, the welding regions 131 of equal lengths are arranged in the first direction, such that the adhesive bonding regions 132 are evenly spaced apart from each other on the conductive component 130. In should be understood that, in other embodiments of the present application, the lengths of the individual welding regions 131 in the first direction may be different from each other; alternatively, a part of the welding regions 131 may be of the same length in the first direction, while another part of the welding regions 131 may be of different lengths in the first direction.

Referring to FIG. 3, FIG. 4, FIG. 6, and FIG. 7, in an embodiment, the lengths of the individual adhesive bonding regions 132 in the first direction are equal to and/or different from each other. The lengths of the adhesive bonding regions 132 in the first direction are not limited in principle, as long as no flux parts 135 is provided in the adhesive bonding regions 132. In this way, the inhibition of the acidic substance in the flux part 135 against the activity of the catalytic substance in the fixing adhesive dot 121 can be avoided, and the bonding force of the fixing adhesive dot 121 through which the conductive component 130 is bonded to the cell 110 can be ensured.

In an embodiment, referring to FIG. 3, FIG. 4, FIG. 6, and FIG. 7, the lengths of the individual adhesive bonding regions 132 in the first direction are equal to each other. That is, the adhesive bonding regions 132 with the equal lengths are arranged in the first direction, such that the welding regions 131 are evenly spaced apart from each other on the conductive component 130. In should be understood that, in other embodiments of the present application, the lengths of the individual adhesive bonding regions 132 in the first direction may be different from each other; alternatively, a part of the adhesive bonding regions 132 are of the same length in the first direction, while another part of the adhesive bonding regions 132 are of different lengths in the first direction.

In an embodiment, the lengths of the welding regions 131 in the first direction are greater than the lengths of the adhesive bonding regions 132 in the first direction. In other words, the lengths of the individual welding regions 131 in the first direction are equal to each other, the lengths of the individual adhesive bonding regions 132 in the first direction are equal to each other, and the lengths of the welding regions 131 are greater than the lengths of the adhesive bonding regions 132.

In this way, a length of the welding connection between the conductive component 130 and the cell 110 is greater than a length of the bonding connection between the conductive component 130 and the cell 110. This not only ensures the reliable connection between the conductive component 130 and the cell 110 through the adhesive bonding connection and the welding connection, but also ensures the length of the electrical connection between the conductive component 130 and the cell 110, thereby ensuring the electrical contact property between the conductive component 130 and the cell 110, and allowing the conductive component 130 to normally collect the currents generated by the cell 110.

In an embodiment, the lengths of the adhesive bonding regions 132 in the first direction are in a range of 1/5 to 1/2 of the lengths of the welding regions 131 in the first direction. As such, the reliable connection between the conductive component 130 and the cell 110 can be ensured, while also ensuring the length of the electrical connection between the conductive component 130 and the cell 110.

Referring to FIG. 3, FIG. 4, FIG. 6, and FIG. 7, in an embodiment, the lengths of the flux parts 135 in the first direction are less than or equal to the lengths of the respective welding regions 131 in the first direction. In other words, the flux parts 135 are at least partially coated on the respective welding region 131 along the first direction, which ensures the length of the electrical connection between the conductive component 130 and the conductive region 111.

Exemplarily, referring to FIG. 3, FIG. 4, FIG. 6, and FIG. 7, the lengths of the flux parts 135 in the first direction are equal to the lengths of the respective welding regions 131 in the first direction. It should be understood that, in other embodiments of the present application, the lengths of the flux parts 135 in the first direction may be less than the lengths of the respective welding regions 131 in the first direction.

Referring to FIG. 3, FIG. 4, FIG. 6, and FIG. 7, in an embodiment, the lengths of the fixing adhesive dots 121 in the first direction are less than or equal to the lengths of the respective adhesive bonding regions 132 in the first direction. In other words, the fixing adhesive dots 121 are at least partially coated on the respective adhesive bonding region 132 in the first direction, which allows the fixing adhesive dots 121 to effectively bond the conductive component 130 to the cell 110.

It should be noted that the type of the conductive component 130 is not limited in principle, as long as the conductive component 130 is electrically conductive. The type of the conductive component 130 can be selected according to needs, as long as the currents in the cell 110 can be effectively collected while reducing the shading rate caused by the conductive component 130 and improving the efficiency of the photovoltaic module.

Referring to FIG. 1, FIG. 2, FIG. 5, and FIG. 6, in an embodiment, the conductive component 130 is a conductive metal wire. The conductive metal wire has a relatively thin wire diameter, which can effectively collect the currents while reducing the shading rate and improving the efficiency of the photovoltaic module. It should be understood that, in other embodiments of the present application, the conductive component 130 may be a conductive metal strip, a conductor wire, etc.

Moreover, after the conductive metal wire is used as the conductive component 130 to collect currents in the present application, when the solar cell string 100 is prepared into the photovoltaic module, a thinner encapsulation film can be used to encapsulate the photovoltaic module, thereby reducing the material costs. Additionally, the usage amount of metal electrodes can be decreased, thereby reducing the manufacturing costs of the photovoltaic module. As such, the solar cell string 100 may use a greater number of finer conductive components 130 to converge currents, thereby shortening a transmission distance of currents and facilitating power improvement.

Referring to FIG. 1, FIG. 2, FIG. 5, and FIG. 6, in an embodiment, a diameter of the conductive component 130 ranges from 0.1 mm to 0.3 mm. In other words, a cross section of the conductive component 130 is circular, and the conductive component 130 is of a fine filamentous structure. As a plurality of conductive components 130 are provided on the cell 110 in the present application, even if the diameter of the conductive component 130 is small, the convergence of currents in the solar cell string 100 will not be affected. In addition, as the diameter of the conductive component 130 is small, the shading of lights can be reduced, the efficiency of the photovoltaic module can be improved, a thinner encapsulation film can be used for encapsulation, the usage amount of the metal electrodes can be reduced, and the manufacturing cost of the photovoltaic module can be lowered.

It should be understood that, in other emboidments of the present application, the cross section of the conductive component 130 is in a shape of an equilateral triangle, and a side length of the cross section of the conductive component 130 ranges from 0.1mm to 0.3 mm. As a plurality of conductive components 130 are provided on the cell 110 in the present application, even if the size of the cross section of the conductive component 130 is small, the convergence of currents in the solar cell string 100 will not be affected. In addition, as the size of the cross section of the conductive component 130 is small, the shading of lights can be reduced, the efficiency of the photovoltaic module can be improved, a thinner encapsulation film can be used for encapsulation, the usage amount of the metal electrodes can be reduced, and the manufacturing cost of the photovoltaic module can be lowered.

Referring to FIG. 1 to FIG. 3, FIG. 5, and FIG. 6, in an embodiment, there are a plurality of adhesive parts 120 arranged spaced apart in the second direction perpendicular to the first direction on the surface of the cell 110. There are a plurality of conductive components 130. Each adhesive part 120 is connected to one conductive component 130. Each conductive component 130 is provided with a plurality of flux parts 135 spaced apart from each other.

In other words, a plurality of adhesive part 120 spaced apart from each other in the second direction are disposed on the surface of the cell 110. Each adhesive part 120 is configured to fix one conductive component 130. A plurality of conductive components 130 are each fixed to the surface of the cell 110 through the welding connection and the bonding connection. As such, the cell 110 can be connected to an adjacent cell 110 through the plurality of conductive components 130, so that the currents generated by the two adjacent cells 110 can be converged, and the cell string can be obtained. Optionally, the arrangements of the fixing adhesive dots 121 in the individual adhesive parts 120 are the same and/or different.

Referring to FIG. 1, FIG. 2, FIG. 5, and FIG. 6, in an embodiment, the conductive component 130 is a conductive metal wire. A plurality of conductive components 130 are fixed to the surface of the cell 110 through the welding connection and the bonding connection. In an embodiment, twenty-four conductive components 130 are provided on the cell 110, and the currents in the cell 110 are converged through the twenty-four conductive components 130 in form of the conductive metal wires. It should be understood that, in other embodiments of the present application, other numbers of the conductive components 130 in form of the conductive metal wires may be provided on the cell 110 to converge currents.

Referring to FIG. 4, FIG. 7, and FIG. 8, in an embodiment, the conductive component 130 includes a conductive base 133 and a metal coating 134. The metal coating 134 is coated on an outer side of the conductive base 133. The flux parts 135 are coated on the metal coating 134 along the perimetral direction. In the welding regions 131, the flux parts 135 are coated on the outer side of the metal coating 134. Moreover, the metal coating 134 of the conductive component 130 is welded to the conductive regions 111 through the flux parts 135 in the welding regions 131, and the metal coating 134 of the conductive component 130 makes contact with the fixing adhesive dots 121 in the adhesive bonding regions 132.

After the metal coating 134 of the conductive component 130 is welded to the conductive regions 111 of the cell 110 through the flux parts 135 in the welding regions 131, an electrical connection between the conductive base 133 and the conductive regions 111 of the cell 110 can be achieved through the metal coating 134, allowing the conductive base 133 to converge the currents generated by the cell 110.

Optionally, the conductive base 133 is a copper strip in an embodiment. It should be understood that, in other embodiments of the present application, the conductive base 133 may be made of other conductive material having a good electric conductivity. Optionally, the metal coating 134 is made of a multi-element solder including, but not limited to, tin, lead, bismuth, silver, etc. A melting point of the metal coating 134 may range from 140°C to 250°C.

In an embodiment, the fixing adhesive dots 121 are made of an adhesive that can be catalytically cured under cure conditions. To prevent the inhibition of the acidic substance in the flux parts 135 against the activity of the catalytic substance in the fixing adhesive dots 121, no flux parts 135 are provided in the adhesive bonding regions 132 in the present application.

In an embodiment, the cure conditions for the fixing adhesive dots 121 may include light, heat, or other types of catalytic conditions. In other words, the fixing adhesive dots 121 may be cured using a light curing method, a heating curing method, or other curing methods.

It should be noted that the shapes of the fixing adhesive dots 121 are not limited in principle, as long as the fixing adhesive dots 121 can bond the adhesive bonding regions 132 of the conductive component 130 to the cell 110. Optionally, the shapes of the fixing adhesive dots 121 may include a hemispherical shape, a square, a linear mosaic, a curved mosaic, a combination of linear and curved mosaics, or other shapes.

Exemplarily, as shown in FIG. 3, the shapes of the fixing adhesive dots 121 are a hemispherical shape, meaning that an outer contour of the fixing adhesive dots 121 is semicircular. It should be understood that, in other embodiments of the present application, the fixing adhesive dots 121 may also be square or other regular or irregular shapes.

In an embodiment, the shapes of the individual fixing adhesive dots 121 are the same as and/or different from each other. Optionally, the shapes of the individual fixing adhesive dots 121 are the same. Optionally, the shapes of the individual fixing adhesive dots 121 are different from each other. Optionally, a part of the fixing adhesive dots 121 have the same shape, while another part of the fixing adhesive dots 121 have different shapes. It should be noted that the shapes of the fixing adhesive dots 121 are not limited in principle, as long as the fixing adhesive dots 121 can bond the conductive component 130 to the cell 110.

In the solar cell string 100 of the present application, the outer periphery of the conductive component 130 is defined with a plurality of welding regions 131 and a plurality of adhesive bonding regions 132. The welding regions 131 and the adhesive bonding regions 132 are alternately arranged in the first direction. The conductive component 130 is provided with the flux parts 135 in the welding regions 131 and without flux parts 135 in the adhesive bonding regions 132. As such, the welding regions 131 of the conductive component 130 and the flux parts 135 thereon can be arranged corresponding to the conductive regions 111 of the cell 110, while the adhesive bonding regions 132 of the conductive component 130 can be arranged corresponding to the fixing adhesive dots 121.

After the conductive component 130 is fixed to the cell 110, the flux parts 135 facilitate the weldingly fixation of the conductive component 130 to the cell 110 in the welding regions 131, and increase the firmness of the connection between the conductive component 130 and the cell 110. Meanwhile, the flux parts 135 of the conductive component 130 do not make contact with the fixing adhesive dots 121, so that the bonding force between the conductive component 130 and the fixing adhesive dots 121 is increased, ensuring the reliability of the bonding connection between the conductive component 130 and the cell 110, and then ensuring a sufficient tightening force between the conductive component 130 and the cell 110, which ensures the reliability of the connection between the conductive component 130 and the cell 110, avoids the issues of poor and loose solder joints between the conductive component 130 and the cell 110, and ensures the performance of the photovoltaic module in use.

Referring to FIG. 1, FIG. 2, FIG. 5, and FIG. 6, the present application further provides a photovoltaic module, including a plurality of solar cell strings 100, a cover plate, and a back plate. The solar cell strings 100 are connected in series in the first direction. The cover plate and the back plate are arranged at two sides of the plurality of solar cell strings 100. The cover plate, the back plate, and the solar cell strings 100 are encapsulated through an encapsulation process.

When the photovoltaic module is prepared using the solar cell string 100 in the above embodiment, the reliability of the connection between the conductive component 130 and the cell 110 is ensured, thereby avoiding the issues of poor and loose solder joints between the conductive component 130 and the cell 110 and thus ensuring the performance of the photovoltaic module in use. Additionally, the shading of the lights by the conductive component 130 can be reduced, the efficiency of the photovoltaic module can be improved, and a thinner encapsulation film can be used to encapsulate the solar cell string 100, lowering the manufacturing cost.

## Claims

1. A conductive component, wherein:
an outer periphery of the conductive component (130) is defined with a plurality of welding regions (131) and a plurality of adhesive bonding regions (132), with the welding regions (131) and the adhesive bonding regions (132) arranged alternately in a first direction; and
the outer periphery of the conductive component (130) is provided with a plurality of flux parts (135) respectively corresponding to the plurality of welding regions (131), and each of the flux parts (135) is at least partially coated, along a perimetral direction of the conductive component (130), on the conductive component (130) in a corresponding one of the welding regions (131).

2. The conductive component according to claim 1, wherein:
in the first direction, one of the welding regions (131) is located at an end of the conductive component (130), such that one of the flux parts (135) is located at the end of the conductive component (130); or
in the first direction, one of the adhesive bonding regions (132) is located at an end of the conductive component (130).

3. The conductive component according to claim 1 or 2, wherein lengths of the welding regions (131) in the first direction are equal to or different from lengths of the adhesive bonding regions (132) in the first direction; or
the welding regions (131) have equal lengths or different lengths in the first direction; or
the adhesive bonding regions (132) have equal lengths or different lengths in the first direction.

4. The conductive component according to any one of claims 1 to 3, wherein lengths of the welding regions (131) in the first direction are greater than lengths of the adhesive bonding regions (132) in the first direction;
optionally, the lengths of the adhesive bonding regions (132) in the first direction are in a range of 1/5 to 1/2 oflengths of the welding regions (131) in the first direction.

5. The conductive component according to any one of claims 1 to 4, wherein the conductive component (130) is a conductive metal wire or a conductive metal strip, and wherein:
the conductive component (130) has a diameter of 0.1 mm to 0.3 mm; or
the conductive component (130) has a cross section in a shape of an equilateral triangle having a side length of 0.1 mm to 0.3 mm.

6. The conductive component according to any one of claims 1 to 5, wherein:
the conductive component (130) comprises a conductive base (133) and a metal coating (134) coated on an outer side of the conductive base (133);
the flux parts (135) are coated on the metal coating (134) along the perimetral direction; and
the flux parts (135) are in a liquid state or in a solid state.

7. A solar cell string, comprising a cell (110), an adhesive part (120), and the conductive component (130) according to any one of claims 1 to 6, wherein:
the adhesive part (120) comprises a plurality of fixing adhesive dots (121) arranged spaced apart in the first direction on a surface of the cell (110) and corresponding respectively to the plurality of adhesive bonding regions (132) of the conductive component (130); and
the conductive component (130) is weldingly fixed to the surface of the cell (110) through the flux parts (135) in the welding regions (131), and adhesively bonded to the fixing adhesive dots (121) in the adhesive bonding regions (132).

8. The solar cell string according to claim 7, wherein:
lengths of the flux parts (135) in the first direction are less than or equal to lengths of the respective welding regions (131) in the first direction; or
lengths of the fixing adhesive dots (121) in the first direction are less than or equal to lengths of the respective adhesive bonding regions (132) in the first direction.

9. The solar cell string according to claim 8, wherein:
there are a plurality of adhesive parts (120) arranged spaced apart in a second direction perpendicular to the first direction on the surface of the cell (110); and
there are a plurality of conductive components (130), each of the adhesive parts (120) is connected to one of the conductive components (130), and each of the conductive components (130) is provided with the plurality of flux parts (135) spaced apart from each other.

10. The solar cell string according to any one of claims 7 to 9, wherein:
the surface of the cell (110) is defined with a plurality of conductive regions (111) arranged spaced apart in the first direction on the surface of the cell (110) and extending in a second direction perpendicular to the first direction;
the conductive regions (111) are corresponding to the welding regions (131), and the conductive component (130) is welded to the conductive regions (111) of the cell (110) through the flux parts (135) in the welding regions (131); and
any adjacent two of the conductive regions (111) is provided with a fixing adhesive dot of the plurality of fixing adhesive dots therebetween.

11. The solar cell string according to claim 10, wherein:
the cell (110) is provided with a plurality of conductive layers (112), and each of the conductive regions (111) is provided with at least one of the conductive layers (112), and the conductive layers (112) extend in the second direction; and
when each of the conductive regions (111) is provided with at least two of the conductive layers (112), the at least two of the conductive layers (112) are spaced apart from each other in the first direction.

12. The solar cell string according to claim 11, wherein the conductive component (130) is perpendicular to the conductive regions (112).

13. The solar cell string according to any one of claims 7 to 12, wherein a welding pad (113) is disposed on the surface of the cell and arranged at each of two opposite ends of the plurality of fixing adhesive dots in the first direction, and the conductive component is welded to the welding pad.

14. The solar cell string according to any one of claims 7 to 13, wherein each of the flux parts makes no contact with the adhesive part.

15. A photovoltaic module, comprising a cover plate, a back plate, and a plurality of solar cell strings (100) according to any one of claims 7 to 14, wherein:
the solar cell strings (100) are connected in series in the first direction;
the cover plate and the back plate are respectively provided at two sides of the plurality of solar cell strings (100); and
the cover plate, the back plate, and the plurality of solar cell strings (100) are encapsulated through an encapsulation process.
